# EUROPEAN PATENT SPECIFICATION

(11) **EP 3 151 270 B1**
(45) Date of publication and mention of the grant of the patent: **01.06.2022**
(21) Application number: 15799652.1
(22) Date of filing: 26.05.2015
(51) Int. Cl.: H01L 23/373, B23K 35/30, B23K 35/36, B22F 1/00, C22C 26/00, H01L 23/10, H01L 23/047, B22F 7/06

(54) **SEMICONDUCTOR PACKAGE AND METHOD FOR MANUFACTURING SAME**
HALBLEITERGEHÄUSE UND VERFAHREN ZUR HERSTELLUNG DAVON
BOÎTIER DE SEMI-CONDUCTEUR ET SON PROCÉDÉ DE FABRICATION

(30) Priority: 27.05.2014 JP 2014109597
(43) Date of publication of application: 05.04.2017
(73) Proprietor: Denka Company Limited, Tokyo 103-8338 (JP)
(72) Inventor: MIYAKAWA Takeshi, Omuta-shi Fukuoka 836-8510 (JP); KINO Motonori, Omuta-shi Fukuoka 836-8510 (JP); ISHIHARA Yosuke, Omuta-shi Fukuoka 836-8510 (JP)
(74) Representative: Beckmann, Claus
(86) International application number: PCT/JP2015/065014
(87) International publication number: WO 2015/182576

(56) References cited:
- CA-A1- 2 843 371
- JP-A- 2001 168 140
- JP-A- 2002 126 869
- JP-A- 2005 340 560
- JP-A- 2012 158 817
- US-A- 5 904 499
- US-A1- 2003 148 024
- US-A1- 2004 119 161
- US-A1- 2011 123 821
- US-A1- 2014 063 757
- Chia-Chen Li ET AL: "Effects of capping agents on the dispersion of silver nanoparticles", COLLOIDS AND SURFACES A: PHYSIOCHEMICAL AND ENGINEERING ASPECTS, vol. 419, 7 December 2012 (2012-12-07), pages 209-215, XP055650367, AMSTERDAM, NL ISSN: 0927-7757, DOI: 10.1016/j.colsurfa.2012.11.077
- RENLIANG XU ET AL: "Comparison of sizing small particles using different technologies", POWDER TECHNOLOGY - ELECTROSTATIC PHENOMENA IN PARTICULATE PROCESSES, ELSEVIER, BASEL (CH), vol. 132, no. 2-3, 24 June 2003 (2003-06-24), pages 145-153, XP002711749, ISSN: 0032-5910, DOI: 10.1016/S0032-5910(03)00048-2
- Giles Humpston ET AL: "Section 4.1.2 - Wetting of Nonmetals by Solders" In: "Principles of Soldering", 1 April 2004 (2004-04-01), ASM International, XP055703913, ISBN: 978-1-61503-170-2 pages 149-152,

## Description

### TECHNICAL FIELD

The present invention relates to a method for manufacturing a semiconductor package.

### BACKGROUND ART

Generally, in semiconductor devices such as semiconductor laser devices used in optical communications and the like, and high-performance MPUs (microprocessing units) and the like, the problem of how to efficiently remove the heat generated by the devices is very important in order to prevent malfunctions or the like. These semiconductor devices are generally used by housing them inside semiconductor packages, so in order to safely and stably operate semiconductor devices housed in these packages, the heat generated when operating the devices must be efficiently dissipated to the outside of the packages. This heat dissipation is usually achieved by transmitting heat from the semiconductor device which is the heat source through a heat dissipating member joined thereto.

In recent years, advances in semiconductor device technologies have led to higher outputs, higher speeds and higher integration of devices, placing ever stricter demands on their heat dissipation. For this reason, higher thermal conductivity is also generally required in heat-dissipating members for semiconductor packages, and copper (Cu), which has a high thermal conductivity of 390 W/mK, is used.

On the other hand, the higher outputs of semiconductor devices have also led to higher operating temperatures, and the problem of mismatches in the thermal expansion between semiconductor devices and the heat dissipating members of semiconductor packages that are directly joined thereto has gained prominence. In order to solve these problems, the development of a heat dissipating member that has the property of high thermal conductivity while also having a coefficient of thermal expansion that matches with that of semiconductor devices has been sought. As such materials, there are composites of metals and ceramics, for example, composites of aluminum (A1) and silicon carbide (SiC) (Patent Document 1).

However, in an Al-SiC composite material, the thermal conductivity will be 300 W/mK or less no matter how the conditions are optimized, so the development of a heat dissipating member having even higher thermal conductivity, greater than the thermal conductivity of copper, has been sought. As such a material, a metal-diamond composite material that combines the high thermal conductivity possessed by diamonds with the high coefficient of thermal expansion possessed by metals, and thus has high thermal conductivity and a coefficient of thermal expansion close to that of semiconductor device materials, has been proposed (Patent Document 2).

Additionally, in Patent Document 3, a β-type SiC layer is formed on the surfaces of diamond grains, thereby suppressing the generation of metal carbides having low thermal conductivity that are formed at the time of compositing, and improving the wettability with molten metals, thereby improving the thermal conductivity of the resulting metal-diamond composite material. As the most preferred mode of this metal-diamond composite material the use of aluminum as the metal matrix is proposed (Patent Document 3).

A further aluminum-diamond composite heat dissipation member is disclosed by US 2011/0123821 A1. Also, US 2014/0063757 A1 discloses a method of joining semiconductor package members using e.g. fine silver particles.
Patent Document 1: JP H9-157773 A
Patent Document 2: JP 2000-303126 A
Patent Document 3: JP 2007-518875 A

### SUMMARY OF THE INVENTION

When using heat dissipating members composed of these metal-ceramic composites as semiconductor packages, an insulation member is joined to this heat dissipating member using a joining material A, and the semiconductor is further joined onto the heat dissipating member or onto the insulation member using a joining material B. While these joining materials are generally brazing materials or the like using active metals, if the joining temperatures are such that the joining temperature of joining material A is lower than that of joining material B, joining material A will melt when joining material B is used, so the joining temperature of joining material A must be higher than the joining temperature of joining material B.

When using a metal-ceramic composite having an aluminum matrix as the heat dissipating member, a brazing material containing gold is generally used as the joining material between the heat dissipating member and the insulation member because the melting temperature of aluminum is around 600 °C, but gold ingots come at a high price, so there is the problem of cost.

Therefore, the purpose of the present invention is to provide an inexpensive semiconductor package having excellent heat dissipation properties.

The present invention provides a method of manufacturing a semiconductor package according to claim 1.

According to one embodiment of the present invention, in the semiconductor package, the diamond grain content in the aluminum-diamond composite is at least 40 vol% and at most 75 vol% with respect to the entire aluminum-diamond composite.

According to one embodiment of the present invention, in the semiconductor package, the joint portion between the heat dissipating member and the joining layer is plated with at least one of Ni, Ag and Au.

According to one embodiment of the present invention, in the semiconductor package, the joint portion between the insulation member and the joining layer is plated with at least one of Ni, Ag and Au.

According to one embodiment of the present invention, in the semiconductor package, a mounting portion for a semiconductor device on the heat dissipating member is plated with at least one of Ni, Ag and Au.

The present invention is able to provide an inexpensive semiconductor package having excellent heat dissipation properties.

### BRIEF DESCRIPTION OF THE DRAWINGS

[Fig. 1] A schematic section view of a semiconductor package according to an embodiment of the present invention.
[Fig. 2] A schematic section view showing a mounting example of a semiconductor device using a semiconductor package according to an embodiment of the present invention.

### MODES FOR CARRYING OUT THE INVENTION

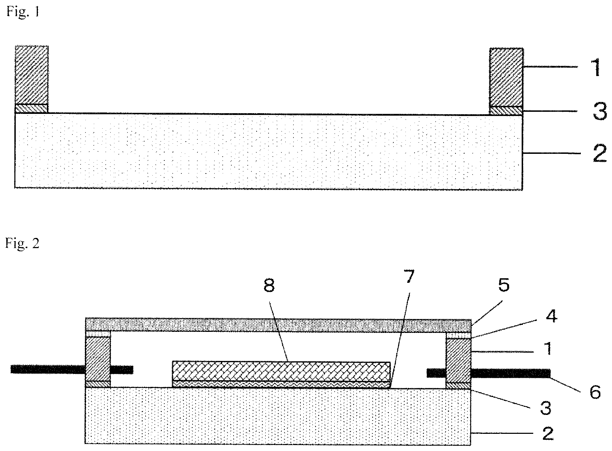

Next, one embodiment of the present invention will be explained. Fig. 1 is a schematic section view of a semiconductor package according to the present embodiment. The semiconductor package of the present embodiment is formed by stacking, in the following order, a heat dissipating member 2, a joining layer 3 and an insulation member 1.

The heat dissipating member 2 according to the present embodiment comprises a flat plate-shaped aluminum-diamond composite containing diamond grains and a metal containing aluminum. The heat dissipating member 2 comprises a composited portion of the aluminum-diamond composite and surface layers provided on both surfaces of the composited portion.

The diamond grain content in the aluminum-diamond composite should preferably be at least 40 vol% and at most 75 vol% of the entire composite comprising of the composited portion of the aluminum-diamond composite and the surface layers. If the diamond grain content is 40 vol% or more, sufficient thermal conductivity is obtained, and if the diamond grain content is 75 vol% or less, the diamond grains and aluminum more easily form a composite.

While the surface layers covering both surfaces of the composited portion of the aluminum-diamond composite comprise a material mainly containing aluminum, such as an aluminum alloy, substances other than metals containing aluminum may also be included. The surface layer contains at least 99 mass% of aluminum.

The thickness of the heat dissipating member 2 of the present embodiment is preferably at least 100 µm and at most 5 mm. If the thickness of the heat dissipating member 2 is 100 µm or more, sufficient strength and rigidity can be obtained as a material for a semiconductor package, and if the thickness of the heat dissipating member 2 is 5 mm or less, the cost of the member is inexpensive, which is favorable as a semiconductor package.

Although there are no particular limitations on the thickness of the surface layer in the heat dissipating member 2, each of the two sides of surface layers should preferably have a thickness that is 20% or less than that of the heat dissipating member 2, in order to achieve good heat dissipation properties.

The joint portion between the heat dissipating member 2 and the joining layer 3 may also be plated. Additionally, since the heat dissipating member 2 is to be joined to a semiconductor device by soldering, the mounting portion for the semiconductor device on the heat dissipating member 2 (the joint portion between the heat dissipating member and the semiconductor device) may also be plated.

When plating the heat dissipating member 2, it is possible to use Ni plating, or two-layer plating by Ni plating and Au plating in consideration of the solder wettability. It is also possible to use Ag plating instead of Au plating. The plating method is not particularly limited, and either electroless plating method or electroplating method may be used.

The plating thickness should preferably be at least 0.5 µm and at most 10 µm. If the plating thickness is 0.5 µm or more, the formation of plating pinholes or solder voids (cavities) during soldering can be prevented, and the heat dissipation properties from the semiconductor device can be ensured. Additionally, if the plating thickness is 10 µm or less, there will be no influence from the low thermal conductivity plating film, and the heat dissipation properties from the semiconductor device can be ensured.

Regarding the purity of the plating film, there are no particular restrictions as long as there is no adverse effect on the solder wettability, and other components such as phosphorous and boron may be included.

The joining layer 3 in the present embodiment is a composite material containing organic-coated silver fine particles, or a composite material containing silver oxide fine particles and organic-coated silver fine particles.

Examples of the above-mentioned silver oxide fine particles include silver oxide (Ag₂O, AgO), and one or more metals chosen from this group may be used.

The above-mentioned organic-coated silver fine particles refer to particles having a nucleus comprising silver coated with an organic protective film. The organic substance is chosen from aliphatic carboxylic acids and amine compounds.

The silver oxide fine particles or organic-coated silver fine particles should have an average particle size of at least 1 nm and at most 100 µm, preferably at least 1 nm and at most 50 µm.

If the average particle size is 100 µm or less, the gaps between the particles can be made smaller and a dense joining layer can be obtained. Additionally, if the average particle size is 1 nm or more, the metal oxide particles themselves can be easily produced.

Additionally, regarding the silver oxide fine particles and the organic-coated silver fine particles, the silver fine particles can be more finely packed by mixing together particles having a small particle size with particles having a large particle size.

Additionally, when using silver oxide fine particles, a reducing agent for reducing silver oxide on the surfaces must also be used, and it is sufficient for the reducing agent to be one having the function of reducing metal oxide particles.

The reducing agent may, for example, be an alcohol, a carboxylic acid or an amine, as well as an organic substance containing an aldehyde group or an ester group, a sulfanyl group or a ketone group, or an organic substance such as a metal salt of a carboxylic acid.

The silver oxide fine particles or organic-coated silver fine particles may be dispersed in a solvent or the like as needed, and used as a joining material in the form of a paste. Aside from the above-mentioned reducing agents, dispersing agents, viscosity adjusting agents, and other metal components for promoting baking or the like may be added to the paste as appropriate.

The organic components in the paste preferably have a weight reduction of at least 95% at the baking temperatures of the silver oxide fine particles or the organic-coated fine particles. If the weight reduction of the organic components is 95% or more, the joining layer can be made sufficiently dense. The weight reduction mentioned here refers to the numerical value when taking measurements using a commercially available TG-DTA measuring device in air at a temperature increase rate of 10 °C/min.

While there are no particular restrictions on the thickness of the joining layer 3, the thickness should preferably be at least 5 µm and at most 200 µm when considering the amount of joining material to be supplied and the convenience of the joining step.

The material of the insulation member 1 is alumina, silicon nitride or aluminum nitride.

The insulation member 1 may be plated. The plating method is not particularly restricted, and either electroless plating method or electroplating method may be used. As specific examples, Ni plating or two-layer plating with Ni plating and Au plating may be used, and Ag plating may be used instead of Au plating.

The plating thickness is preferably at least 0.5 µm and at most 10 µm. If the plating thickness is 0.5 µm or more, plating pinholes can be prevented, and heat dissipation properties from the semiconductor device can be ensured. Additionally, if the plating thickness exceeds 10 µm, the cost becomes expensive.

Plating the joint portion between the insulation member 1 and the joining layer 3 has the effect of obtaining good joining properties with the joining layer 3.

The joining temperature of the joining layer 3 with respect to the insulation member 1 and the heat dissipating member 2 must be lower than the melting points of the other materials used in the semiconductor package, while being high enough to cause evaporation of the organic solvents.

Additionally, the joining temperature is preferably lower in order to reduce the stress on the semiconductor package after joining. Specifically, joining is possible without the temperature affecting the other members if the joining temperature is at least 180 °C and at most 550 °C. On the other hand, the joining temperature should preferably be at least 300 °C in order to prevent the joining layer 3 from melting during solder joining in the process of mounting a semiconductor on the resulting semiconductor package. According to the invention, the joining temperature is 520-550 °C.

One preferred mode for forming the joining layer 3 of the present embodiment is by applying the joining material in paste form between the members, and heating and pressurizing to form the joining layer. However, the form of the joining material is not limited to that of a paste, and a sheet-type joining material may also be used.

The semiconductor package according to the above-described embodiment is inexpensive, has excellent heat dissipation properties, and can be favorably applied to power semiconductor modules or the like.

Fig. 2 is a schematic section view showing an example of the mounting of a semiconductor device using the semiconductor package according to an embodiment of the present invention. The semiconductor 8 is joined to the heat dissipating member 2 via a solder joining layer 7. The cap material 5 is joined to the insulation member 1 via a cap material joining layer 4. The material of the cap material joining layer 4 may be an Au-based brazing material, or the same material as the joining layer 3.

### EXAMPLES

Herebelow, the present invention will be explained in further detail by providing examples and comparative examples.

### [Example 1]

As a heat dissipating member, an aluminum-diamond composite containing 60 vol% , with respect to the entire aluminum-diamond composite, of diamond grains having an average grain size of 130 µm, having aluminum surface layers with an aluminum content of at least 99% and a thickness of 50 µm on both front and back, and an overall thickness of 1.5 mm, was machined to a size of 10 mm × 10 mm.

As a joining layer, a paste obtained by mixing silver fine particles having an average particle size of 8 nm coated with an amine compound (octylamine) and silver fine particles having an average particle size of 190 nm at a mass ratio of 1:7, and dispersing the mixed powder in terpineol to form a paste having a solid content of 70 mass% was used. The paste was coated to a thickness of 10 µm onto the aluminum-diamond composite, the joining was performed in a vacuum at 520 °C using alumina having a thickness of 1 mm as an insulation member, and then Ni-plating, and further Au-plating were performed to obtain a semiconductor package.

### [Example 2]

A semiconductor package was obtained in the same manner as in Example 1, except that both the heat dissipating member and the insulation member were Ni-plated before joining, then Au-plated after joining.

### [Example 3]

A semiconductor package was obtained in the same manner as in Example 1, except that both the heat dissipating member and the insulation member were Ni-plated, and further Au-plated before joining.

### [Comparative Example]

As a heat dissipating member, an aluminum-diamond composite having a diamond grain content of 60 vol% with respect to the entire aluminum-diamond composite, having aluminum surface layers in a thickness of 50 µm on both front and back, and an overall thickness of 1.5 mm, was machined to a size of 10 mm × 10 mm.

As a joining layer, a brazing material containing 40 mass% of Ag, 30 mass% of Cu and 30 mass% of Zn was used. A paste of this brazing material was coated to a thickness of 10 µm onto the aluminum-diamond composite, and joining was performed in a vacuum at 550 °C using alumina having a thickness of 1 mm as an insulation member.

While Examples 1 to 3 were able to achieve sufficient joining and were able to manufacture semiconductor packages, the comparative example was not able to achieve sufficient joining and a semiconductor package was not able to be manufactured. This is because the joining material (brazing material) did not sufficiently melt at the joining temperature in the comparative example. On the other hand, if the temperature is raised to sufficiently melt the joining material of the comparative example, the other members also melt and their shapes are deformed.

As can be understood from the above-described results, the semiconductor packages of Examples 1 to 3 achieved sufficient joining. The semiconductor packages joined in this way have the advantage of excellent heat dissipation properties. Additionally, in the joining layer, a composite material containing relatively inexpensive silver oxide fine particles or organic-coated silver fine particles is used. Thus, the present invention can be understood to provide an inexpensive semiconductor package that has excellent heat dissipation properties.

### DESCRIPTION OF THE REFERENCE NUMBERS

- 1: insulation member
- 2: heat dissipating member
- 3: joining layer
- 4: cap material joining layer
- 5: cap material
- 6: lead
- 7: solder joining layer
- 8: semiconductor

## Claims

1. A method for manufacturing a semiconductor package containing a heat dissipating member (2), an insulation member (1) and a joining layer (3),
wherein
the heat dissipating member (2) comprises an aluminum-diamond composite containing diamond grains and a metal containing aluminum,
the insulation member (1) is composed of alumina, silicon nitride or aluminum nitride,
the heat dissipating member (2) comprises a composited portion of the aluminum-diamond composite and surface layers provided on both surfaces of the composited portion, and
the surface layers are composed of at least 99 mass-% of aluminum,
**characterized in that** the method comprises:
a step of providing a composite material containing an aliphatic carboxylic acid or an amine compound coated silver fine particles having an average particle size of at least 1 nm and at most 100 µm in a joint portion between the heat dissipating member (2) and the insulation member (1); and
a step of heating to a temperature of at least 520 °C and at most 550 °C so as to form the composite material into the joining layer (3) joining the heat dissipating member (2) and the insulation member (1).

## Patentansprüche

1. Verfahren zur Herstellung eines Halbleiterpakets, enthaltend ein wärmeableitendes Element (2), ein Isolierelement (1) sowie eine Verbindungsschicht (3),
wobei
das wärmeableitende Element (2) einen Aluminium-Diamant-Verbund umfasst, enthaltend Diamantkörner und ein Aluminium enthaltendes Metall,
das Isolierelement (1) aus Aluminiumoxid, Siliciumnitrid oder Aluminiumnitrid besteht,
das wärmeableitende Element (2) einen Verbundteil aus dem Aluminium-Diamant-Verbund und Oberflächenschichten, die auf beiden Oberflächen des Verbundteils angebracht sind, umfasst, und
die Oberflächenschichten bestehen aus wenigstens 99 Massen-% Aluminium,
**dadurch gekennzeichnet, dass** das Verfahren umfasst:
einen Schritt des Bereitstellens eines Verbundmaterials, enthaltend eine aliphatische Carbonsäure oder mit einer Aminverbindung beschichtete Silberfeinpartikel mit einer durchschnittlichen Teilchengröße von wenigstens 1 nm und höchstens 100 µm in einem Verbindungsbereich zwischen dem wärmeableitendem Element (2) und dem Isolierelement (1); sowie
einen Schritt des Erhitzens auf eine Temperatur von wenigstens 520°C und höchstens 550°C unter Bildung des Verbundmaterials in der Verbindungsschicht (3), welche das wärmeableitende Element (2) und das Isolierelement (1) verbindet.

## Revendications

1. Procédé de fabrication d'un boîtier de semi-conducteur contenant un élément de dissipation de chaleur (2), un élément d'isolation (1) et une couche de liaison (3),
dans lequel
l'élément de dissipation de chaleur (2) comprend un composite aluminium-diamant contenant des grains de diamant et un métal contenant de l'aluminium,
l'élément d'isolation (1) est composé d'alumine, de nitrure de silicium ou de nitrure d'aluminium,
l'élément de dissipation de chaleur (2) comprend une partie composite d'aluminium-diamant et des couches de surface prévues sur les deux surfaces de la partie composite, et
les couches de surface sont composées d'au moins 99 % en masse d'aluminium,
**caractérisé en ce que** le procédé comprend :
une étape consistant à fournir un matériau composite contenant de fines particules d'argent revêtu d'un acide carboxylique aliphatique ou d'un composé aminé ayant une taille moyenne de particule d'au moins 1 nm et d'au plus 100 µm dans une partie de jointure entre l'élément de dissipation de chaleur (2) et l'élément d'isolation (1) ; et
une étape de chauffage à une température d'au moins 520 °C et d'au plus 550 °C de manière à former le matériau composite dans la couche de liaison (3) reliant l'élément de dissipation de chaleur (2) et l'élément d'isolation (1).
